# FASCICULE DE BREVET EUROPEEN

(11) **EP 0 312 466 B1**
(45) Date de publication et mention de la délivrance du brevet: **04.08.1993**
(21) Numéro de dépôt: 88420302.7
(22) Date de dépôt: 08.09.1988
(51) Int. Cl.: H01L 21/316, H01L 21/84

(54) **Procédé de fabrication d'une structure de silicium sur isolant**
Verfahren zur Herstellung einer Siliziumstruktur auf einem Isolator
Process of manufacturing a silicon structure on isolator

(30) Priorité: 11.09.1987 FR 8712913
(43) Date de publication de la demande: 19.04.1989
(73) Titulaire: FRANCE TELECOM, 75015 Paris (FR)
(72) Inventeur: Bomchil, Guillermo, F-38170 Seyssins (FR); Halimaoui, Aomar, F-38610 Gières (FR); Herino, Roland, F-38330 Saint Ismier (FR)
(74) Mandataire: de Beaumont, Michel

(56) Documents cités:
- JOURNAL OF APPLIED PHYSICS, vol. 60, no. 1, juillet 1986, pages 222-225, Woodburg, US ; H. TAKAI et al : "Porous silicon layers and its oxide for the silicon-on-isolator structure".
- ELECTRONICS WEEK, vol. 57, no. 25, octobre 1984, pages 11-12, New York, US ; J.R. LINEBACK : "Buried oxide marks route to SOI chips".
- JAPANESE JOURNAL OF APPLIED PHYSICS, vol. 19, no. 2, février 1980, pages 231-241, Tokyo, JP ; T. UNAGAMI : "Oxidation of porous silicon and properties of its oxide film".

## Description

La présente invention concerne le domaine de la fabrication des circuits intégrés sur silicium, et plus particulièrement les circuits intégrés fabriqués sur une couche mince de silicium formée sur une couche isolante.

Les avantages de la fabrication des circuits intégrés sur silicium sur isolant par rapport aux circuits intégrés sur silicium massif ont été soulignés depuis longtemps. Il s'agit par exemple de la simplicité de l'isolement entre composants élémentaires distincts, de l'immunité aux particules ionisantes, etc. Néanmoins, dans la pratique, les circuits intégrés à base de silicium sur isolant n'ont pas connu de développements importants ces dernières années par rapport aux circuits intégrés sur silicium massif. Ceci est essentiellement dû à la difficulté de réalisation d'une couche de silicium monocristallin sur isolant et de la difficulté d'obtention de grandes zones monocristallines de silicium sur isolant. Un procédé de fabrication d'une couche de silicium sur isolant comprenant les étapes consistant à implanter des ions oxygène dans un substrat de silicium monocristallin pour former une couche enterrée d'oxyde de silicium puis à recuire la structure ainsi obtenue est par exemple décrit dans le document Electronics Week, vol. 57, no. 25, octobre 1984, pages 11-12.

Un objet de la présente invention est de prévoir un procédé de fabrication d' une couche de silicium sur isolant qui soit particulièrement simple à mettre en oeuvre et qui permette de choisir dans une large gamme de valeurs l'épaisseur de la couche de silicium.

Cet objet est atteint en prévoyant un procédé de fabrication d'une structure de silicium sur isolant à partir d'une plaquette de silicium monocristallin, comprenant les étapes consistant à former une couche de silicium poreux sur une première face de plaquette ; à oxyder anodiquement le silicium poreux et former ainsi une couche d'oxyde de silicium à l'interface silicium-silicium poreux tout en conservant la partie non oxydée de la couche poreuse; et à recristalliser la couche de silicium poreux restante par traitement thermique au voisinage de la température de fusion du silicium.

Selon un mode de réalisation de la présente invention la deuxième face de la plaquette de silicium comprend une zone surdopée.

Selon une variante de réalisation de la présente invention la plaquette comprend une couche surdopée située à la profondeur à laquelle on arrête la formation de la couche de silicium poreux.

Selon un mode de réalisation de la présente invention l'oxydation anodique est réalisée dans de l'eau pure.

Selon un mode de réalisation de la présente invention la couche de silicium poreux est réalisée par traitement anodique dans un électrolyte comprenant 30 % d'acide fluorhydrique, 35 % d'éthanol et 35 % d'eau.

Ces objets, caractéristiques et avantages ainsi que d'autres de la présente invention sont exposés plus en détail dans la description suivante de modes de réalisation particuliers faite en relation avec les figures jointes parmi lesquelles :
les figures 1 à 4 représentent des étapes successives de fabrication d'une couche mince de silicium sur isolant selon la présente invention ; et
les figures 5 à 7 représentent des étapes successives d'une variante du procédé selon la présente invention.

Dans ces figures, de mêmes références désignent de mêmes couches ou éléments. En outre, comme cela est usuel dans le domaine de la représentation des semiconducteurs, les dimensions des diverses couches ne sont pas tracées à l'échelle pour améliorer la lisibilité des figures.

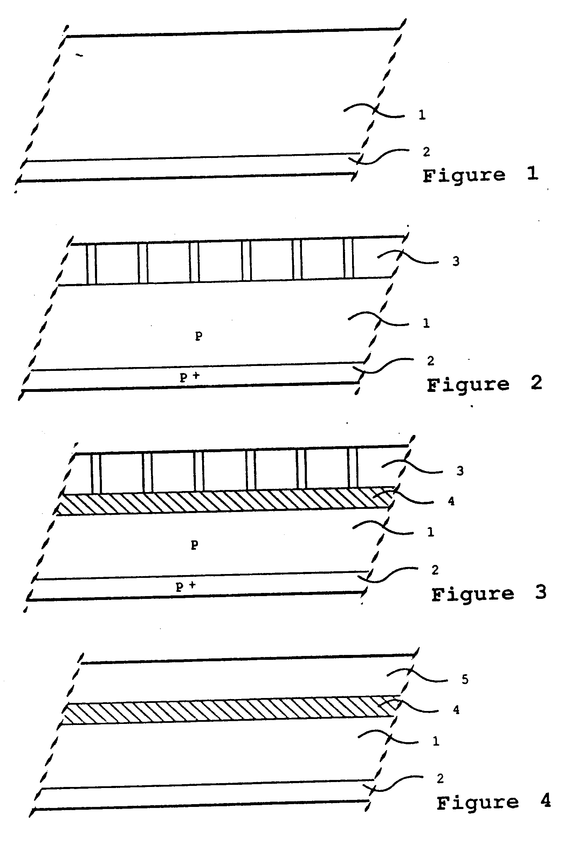

Comme le représente la figure 1, le procédé selon la présente invention est mis en oeuvre sur une plaquette de silicium monocristallin 1 de type N ou P de niveau de dopage et d'orientation cristallographique quelconques. De préférence, la face arrière de la plaquette de silicium 1 comprend une zone surdopée 2 pour faciliter le contact lors de l'étape ultérieure de traitement anodique.

Ensuite, comme le représente la figure 2, une couche de silicium poreux 3 est formée sur le substrat 1. Les conditions de préparation de la couche de silicium poreux devront être adaptées au substrat. Elles sont bien définies et connues dans la technique. Le silicium poreux est par exemple obtenu par dissolution anodique dans un électrolyte constitué d'acide fluorhydrique, d'éthanol et d'eau. La plaquette de silicium est placée dans une cellule d'anodisation où la cathode est une électrode de métal inattaquable tel que du platine. Le contact électrique sur la face arrière de silicium peut être amené par une solution électrolytique ou une métallisation de face arrière.

L'anodisation peut être réalisée à potentiel ou à courant constant. De meilleurs résultats sont en général obtenus à courant constant. La composition de l'électrolyte et la valeur du courant ou du potentiel d'anodisation sont choisies pour obtenir la porosité souhaitée. Par exemple, pour un substrat de type P d'environ 10 Ω.cm, on prendra un électrolyte composé de 30 % HF, 35 % éthanol, 35 % H2O et un courant correspondant à une densité de courant de 50 mA/cm² pour obtenir une porosité d'environ 50 %.

Le temps d'anodisation détermine l'épaisseur de la couche de silicium poreux formé. Dans l'exemple choisi, il faut compter 1C/cm² pour obtenir 1 µm de silicium poreux. Pour obtenir une structure de silicium sur isolant semblable à celles développées aujourd'hui, on peut choisir une épaisseur de l'ordre de 2 µm, mais il n'y a aucune limitation pour le choix d'autres épaisseurs.

Ensuite, comme le représente la figure 3, on procède ensuite à une oxydation anodique du silicium poreux. Cette étape constitue un point essentiel de la présente invention car les procédés classiques d'oxydation du silicium poreux basés sur la diffusion d'une espèce oxydante conduisent tous à une oxydation de toute l'épaisseur de la couche. Un tel procédé d'oxydation volumique de silicium poreux est décrit par exemple dans le document Japanese Journal of Applied Physics, vol. 19, no. 2, février 1980, pages 231-241. Quand on procède par oxydation anodique, l'oxydation procède, par contre, selon les expériences effectuées par les inventeurs, à partir de l'interface avec le substrat. Au fur et à mesure que la couche d'oxyde s'épaissit, la réaction d'oxydation progresse vers la surface de la couche de silicium poreux. L'oxydation anodique est interrompue quand on a formé l'épaisseur d'oxyde souhaité. Le contrôle de cette épaisseur est obtenu par simple coulométrie après avoir préalablement établi une courbe d'étalonnage où l'épaisseur d'oxyde anodique est reliée à la quantité d'électricité mise en jeu durant l'oxydation électrochimique.

A titre d'exemple, la procédure d'oxydation de la couche poreuse formée sur un substrat P dans les conditions décrites dans l'étape 1 est la suivante. Après formation de la couche poreuse et vidange de la solution d'acide fluorhydrique, l'échantillon est abondamment rincé à l'eau désionisée, et la cellule est finalement remplie d'eau de haute résistivité (supérieure à 18.10⁶ Ω.cm). L'oxydation est réalisée dans la même cellule, en imposant un courant constant (0,1 à 1 mA/cm²).

Le potentiel d'électrolyse et la quantité de coulombs échangés sont mesurés pendant la réaction, et l'anodisation est interrompue pour une quantité de coulomb de 0,6 C/cm2, correspondant à l'oxydation de 1 µm de la couche poreuse.

L'oxydation anodique peut être réalisée avec d'autres électrolytes que l'eau mais les oxydes de meilleure qualité ont actuellement été obtenus avec de l'eau pure.

Enfin, dans une étape finale illustrée en figure 4, un traitement thermique est effectué pour transformer la couche de silicium poreux 3 en une couche de silicium monocristallin.

Cette étape permet, d'une part, de concentrer tout l'oxyde 4 formé en une couche dense présentant des interfaces abruptes et régulières avec le silicium et, d'autre part, de réorganiser et de densifier la couche poreuse restante pour la transformer en une couche dense de silicium monocristallin. Il est souhaitable dans cette étape de travailler aux températures les plus hautes possibles pouvant aller jusqu'à la fusion de la couche superficielle de silicium.

Pour l'échantillon traité précédemment, un recuit de 1 heure à 1350°C sous atmosphère d'argon permet d'obtenir une couche monocristalline d'environ 0,5 µm (5000 Å) sur une couche de silice d'épaisseur comparable.

Le traitement thermique peut être réalisé dans des fours commercialement disponibles ou par d'autres méthodes telles que le recuit thermique transitoire en utilisant des systèmes de lampes, laser, faisceau d'électrons, entre autres...

Il peut être intéressant d'encapsuler la couche superficielle avant traitement thermique, par exemple par un dépôt de silicium amorphe réalisé par pulvérisation cathodique ou évaporation sous vide.

Une préamorphisation de la couche superficielle avant traitement thermique par implantation ionique de silicium peut être aussi utilisée pour favoriser la réorganisation du silicium poreux.

Un avantage important du procédé selon la présente invention est que le silicium poreux formé à partir de silicium monocristallin conserve un caractère cristallin et refournit du silicium monocristallin non poreux après recuit.

Toutefois, il est connu que le silicium poreux sera plus monocristallin si l'on part d'un substrat P ou N très dopé. Ceci n'est par nécessairement souhaitable car, dans certaines applications, on peut au contraire souhaiter obtenir une couche mince de silicium monocristallin peu dopé sur l'isolant.

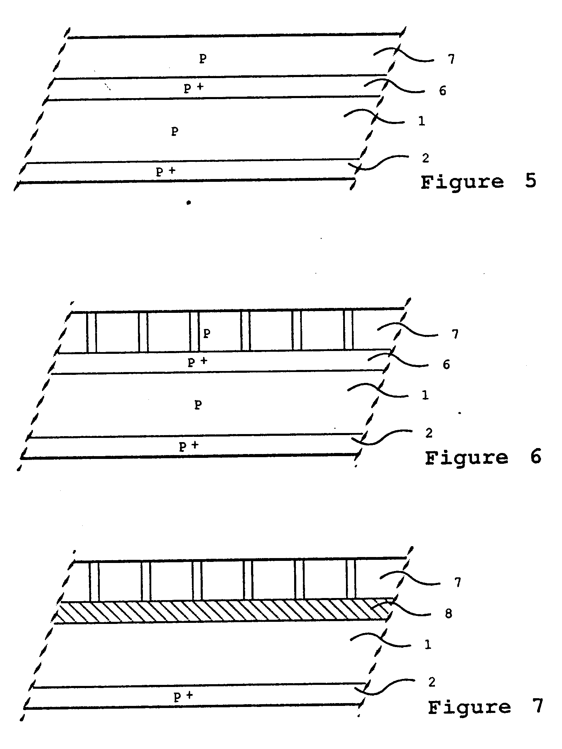

Les figures 5 à 7 illustrent une variante du procédé selon la présente invention où l'on utilise un substrat initial dopé de façon inhomogène. Ce substrat comprend une plaquette de silicium 1 dont la face arrière présente une couche surdopée 2. Du côté de la face avant, une couche fortement dopée 6 est formée et revêtue, par exemple par épitaxie, d'une couche 7 plus faiblement dopée. Dans la figure, toutes ces couches ont été indiquées comme étant de type P. Elles pourraient aussi bien être de type N. Ensuite, comme le représente la figure 6, la face supérieure de la plaquette de silicium est transformée en une couche de silicium poreux sur l'épaisseur des couches 6 et 7 de la figure 5. Le fait que l'on dispose d'une sous-couche 6 plus fortement dopée fournit, même pour la partie supérieure de la couche, un meilleur caractère monocristallin après transformation en silicium poreux. Ensuite, comme le représente la figure 7, on procède à une oxydation anodique selon la présente invention sensiblement sur l'épaisseur de la couche surdopée 6 pour fournir une couche d'oxyde 8. Après cela, on procède au traitement traitement thermique pour arriver à une structure finale telle que celle illustrée en figure 4.

On notera également que la porosité d'une couche de silicium poreux formée à courant (ou à potentiel) constant dans un substrat uniformément dopé est homogène. Dans certains cas on peut avoir intérêt à ce que la couche de silicium poreux présente une porosité plus faible afin de faciliter la réorganisation et la densification lors du traitement thermique. Ceci peut être facilement réalisé soit en modifiant le courant (ou le potentiel) pendant l'anodisation soit en anodisant un substrat présentant un gradient de dopage.

Selon une autre variante du procédé selon la présente invention, on pourra procéder à l'oxydation anodique de la plus grande partie de l'épaisseur de la couche de silicium poreux en ne conservant qu'une fine couche de silicium poreux en surface. On procéde ensuite au dépôt par épitaxie d'une couche de silicium monocristallin sur la fine couche de silicium poreux. Pour cela un traitement thermique a lieu en présence d'hydrogène et/ou de silane selon les techniques et aux températures classiques de croissance épitaxiale. On procéde enfin au traitement thermique à haute température selon la présente invention.

## Revendications

1. Procédé de fabrication d'une structure de silicium sur isolant à partir d'une plaquette de silicium monocristallin, comprenant les étapes suivantes :
former une couche de silicium poreux (3) sur une première face de la plaquette (1);
oxyder anodiquement le silicium poreux, et former ainsi une couche d'oxyde de silicium (4) à l'interface silicium-silicium poreux tout en conservant la partie non oxydée de la couche poreuse;
recristalliser la couche de silicium poreux restante par traitement thermique au voisinage de la température de fusion du silicium.

2. Procédé selon la revendication 1, caractérisé en ce que la deuxième face de la plaquette de silicium comprend une zone surdopée (2).

3. Procédé selon la revendication 1, caractérisé en ce que la plaquette comprend une couche surdopée (6) située à la profondeur à laquelle on arrête la formation de la couche de silicium poreux.

4. Procédé selon la revendication 1, caractérisé en ce que l'oxydation anodique est réalisée dans de l'eau pure.

5. Procédé selon la revendication 1, caractérisé en ce que la couche de silicium poreux est réalisée par traitement anodique dans un électrolyte comprenant 30 % d'acide fluorhydrique, 35 % d'éthanol et 35 % d'eau.

6. Procédé selon la revendication 1, caractérisé en ce qu'il comprend en outre l'étape de dépôt par épitaxie d'une couche de silicium monocristallin sur la surface du silicium poreux après l'étape d'oxydation anodique.

## Claims

1. A method for manufacturing a silicon on insulator structure from single-crystal silicon wafer, comprising the following steps:
forming a porous silicon layer (3) on a first surface of said wafer (1);
anodically oxidizing the porous silicon, thus forming a silicon oxide layer (4) at the silicon-porous silicon interface while maintaining a non-oxidized portion of the porous layer; and
recrystallizing the remaining porous silicon layer by means of thermal treatment at approximately the melting temperature of silicon.

2. The method of claim 1, characterized in that the second surface region of the silicon wafer includes a second overdoped area (2).

3. The method of claim 1, characterized in that the wafer includes an overdoped layer (6) disposed at the depth where the formation of the porous silicon layer is stopped.

4. The method of claim 1, characterized in that the anodic oxidation is carried out in pure water.

5. The method of claim 1, characterized in that the porous silicon layer is formed through anodic treatment in an electrolyte composed by 30% of fluohydric acid, 35% of ethanol and 35% of water.

6. The method of claim 6, characterized in that it further includes the step of epitaxially growing a single-crystal silicon layer on the surface of the porous silicon after the anodic oxidation step.

## Patentansprüche

1. Verfahren zur Herstellung einer Siliziumstruktur auf einem Isolator ausgehend von einem monokristallinen Siliziumplättchen, mit folgenden Schritten:
Bilden einer porösen Siliziumschicht (3) auf einer ersten Oberfläche des Plättchens (1);
Anodisches Oxidieren des porösen Siliziums, wodurch eine Schicht Siliziumoxid (4) in der Grenzschicht Silizium-poröses Silizium unter Beibehaltung des nicht oxidierten Teiles der porösen Schicht gebildet wird;
Rekristallisieren der verbleibenden porösen Siliziumschicht durch eine thermische Behandlung in der Nähe der Schmelztemperatur des Siliziums.

2. Verfahren nach Anspruch 1, dadurch gekennzeichnet, daß die zweite Oberfläche des Siliziumplättchens eine hochdotierte Zone (2) aufweist.

3. Verfahren nach Anspruch 1, dadurchg gekennzeichnet, daß das Plättchen eine hochdotierte Schicht (6) aufweist, die in einer Tiefe liegt, in der die Ausbildung der porösen Siliziumschicht gestoppt wurde.

4. Verfahren nach Anspruch 1, dadurch gekennzeichnet, daß das anodische Oxidieren in reinem Wasser erfolgt.

5. Verfahren nach Anspruch 1, dadurch gekennzeichnet, daß die poröse Siliziumschicht durch anodisches Behandeln in einem Elektrolyten gebildet wird, der 30 % Flußsäure, 35 % Ethanol und 35 % Wasser enthält.

6. Verfahren nach Anspruch 1, dadurch gekennzeichnet, daß es außerdem den Schritt aufweist, eine monokristalline Siliziumschicht epitaktisch auf der Oberfläche des porösen Siliziums nach dem Schritt des anodischen Oxidierens aufzubauen.
